# DEMANDE DE BREVET EUROPEEN

(11) **EP 4 748 964 A1**
(43) Date de publication de la demande: **27.05.2026**
(21) Numéro de dépôt: 24215563.8
(22) Date de dépôt: 26.11.2024
(51) Int. Cl.: C23C 14/00, C23C 14/02, C23C 14/06, C23C 14/08, C23C 14/14, C23C 14/16, C23C 16/455, C23C 28/00, G04B 19/12, G04D 3/00

(54) **PROCÉDÉ DE DÉCORATION DE COMPOSANTS HORLOGERS**

(71) Demandeur: The Swatch Group Research and Development Ltd, 2074 Marin (CH)
(72) Inventeur: SPASSOV, Vladislav, 1788 Praz (CH); CURCHOD, Loïc, 1004 Lausanne (CH); MORADI, Mina, 4600 Olten (CH); SPRINGER, Simon, 3007 Berne (CH)
(74) Mandataire: ICB SA

(57) **Abrégé**

L'invention concerne un procédé de décoration d'un composant horloger avec un revêtement blanc. Le procédé comprend la préparation du composant horloger, le dépôt dans une enceinte de déposition d'une couche d'accroche métallique sur tout le composant horloger via un dépôt physique en phase vapeur, le dépôt d'une couche diffusante en aluminium sur tout le composant sous un flux d'un gaz réactif de sorte que la couche d'aluminium se dépose sous la forme d'une structure cristalline à facettes via un dépôt physique en phase vapeur jusqu'à une épaisseur souhaitée, la déposition sur cette couche d'aluminium d'une couche dure qui la protège mécaniquement mais préserve sa texture facettée via un dépôt physique en phase vapeur, la déposition sur cette couche dure d'une couche métallique fine très réfléchissante via un dépôt physique en phase vapeur, et enfin la déposition par la méthode ALD sur cette couche réfléchissante d'une couche transparente de protection et/ou d'augmentation de la réflexion.

## Description

### Domaine technique de l'invention

L'invention se rapporte à un revêtement présentant une surface de couleur blanche obtenue par une superposition de couches déposées par PVD et ALD. L'invention concerne également des composants horlogers présentant une telle surface blanche.

### Arrière-plan technologique

L'industrie de l'horlogerie est constamment à la recherche de nouvelles solutions en termes de couleurs et d'apparence. Les articles horlogers de couleur blanche, tels que les cadrans, sont souvent obtenus par l'utilisation de nacres ou l'application d'émail.

La surface des métaux nobles tels que l'argent, le platine, le palladium, ou encore le rhodium permet d'obtenir une apparence éclatante. Il est aussi possible d'obtenir une telle apparence par le dépôt galvanique de ces métaux. Cependant, ils réfléchissent la lumière de manière spéculaire, ce qui confère à la surface de l'article un éclat brillant métallique. Le paramétrage judicieux du procédé de dépôt galvanique permet une diminution du reflet spéculaire de ce revêtement qui devient alors blanc mat.

Les techniques de dépôt physique sous vide en phase vapeur (PVD), par exemple la pulvérisation cathodique, permettent d'obtenir des revêtements minces avec des propriétés prédéfinies sur des substrats de différentes natures et ayant une géométrie complexe (tridimensionnelle).

Plusieurs autres substances naturelles possèdent une couleur blanche. A titre d'exemple, citons des pigments constitués de microparticules de substances minérales telles que l'oxyde de titane ou d'aluminium. Ces particules réfléchissent la lumière de manière diffuse. Ces pigments sont déposés sous forme de peintures, laques ou émaux sur la surface des articles.

Cependant, les revêtements de couleur blanche à base de pigments ne permettent pas d'obtenir une qualité de décor suffisante et satisfaisante. En effet, ils ne permettent pas de conserver l'état de surface du substrat, ni de conserver précisément les détails des décorations. Aussi, les revêtements galvaniques de l'art antérieur présentent un aspect matifiant et sont relativement fragiles.

Il existe donc un besoin de disposer d'un revêtement blanc permettant de conserver l'état de surface du substrat et les détails des décorations.

### Résumé de l'invention

L'invention a notamment pour objectif de pallier les différents inconvénients des procédés de l'art antérieur.

Plus précisément, un objectif de l'invention est de proposer un procédé de fabrication d'un revêtement blanc « porcelaine » conservant l'état de surface du substrat poli, mat, soleillé ou toute autre décoration, ainsi qu'un composant horloger avec une surface revêtue d'une couche mince de couleur blanche obtenue par ce procédé.

A cet effet, l'invention concerne un procédé de décoration d'un composant horloger avec un revêtement blanc comprenant les étapes suivantes :
- préparation du composant horloger et installation dudit composant dans une enceinte de déposition ;
- dépôt d'une couche d'accroche métallique sur tout le composant horloger via un dépôt physique en phase vapeur ;
- dépôt d'une couche diffusante en aluminium sur tout le composant, sous un flux d'un gaz réactif, tel que la couche déposée contient entre 0.5% et 10% atomiques de ce gaz, de manière que la couche d'aluminium cristallise sous la forme d'une structure cristalline à facettes, via un dépôt physique en phase vapeur ;
- dépôt d'une couche dure sur la couche diffusante pour augmenter la résistance de la couche diffusante contre les rayures et endommagements mécaniques tout en préservant la texture de la couche diffusante ;
- dépôt d'une couche de métal pur pour augmenter la réflectivité des couches déposées précédemment ;
- dépôt d'une couche transparente, par la méthode ALD ou autre méthode de dépôt sous vide, pour augmenter l'aspect blanc diffusant par effet interférentiel, et pour protéger chimiquement les couches déposées dans les étapes précédentes ;
- alternativement, dépôt d'une couche de protection transparente via un dépôt par la méthode ALD ou autre méthode de dépôt sous vide.

Conformément à d'autres variantes avantageuses de l'invention :
- la couche d'accroche est une couche métallique ou d'un alliage métallique qui peut être choisi parmi : l'aluminium, le titane, l'aluminure de titane, le nickel ou le chrome ;
- la couche d'accroche présente une épaisseur au minimum de 5 nm ;
- la couche diffusante présente une épaisseur comprise entre 300 nm et 6000 nm, de préférence entre 1000 nm et 2000 nm, de préférence de 1500 nm ;
- la couche dure présente une épaisseur comprise entre 100 nm et 3000 nm, de préférence entre 400 nm et 2000 nm, de préférence de 1000 nm ;
- la couche dure est réalisée en un matériau choisi parmi le DLC, les nitrures ou carbonitrures, les oxynitrures ou oxydes de titane, de titane-aluminium, de silicium, d'aluminium, le nickel ou le chrome ;
- la couche finale de métal pur présente une épaisseur comprise en 20 nm et 400 nm, de préférence de 200 nm ;
- la couche de métal pur est réalisée à partir d'un métal à haute réflectivité choisi parmi l'aluminium, l'argent, le rhodium ou le chrome ;
- la couche transparente comprend un empilement de couches diélectriques transparentes ;
- les couches diélectriques transparentes présentent un indice de réfraction entre 1,38 et 2,6 à 633 nm longueur d'onde et une épaisseur entre 5 nm et 500 nm ;
- la couche de protection transparente présente une épaisseur comprise entre 0.5 nm et 20 nm, de préférence de 2 nm ;
- la couche de protection transparente peut être choisie parmi les matériaux suivants : dioxyde de titane, oxyde d'aluminium, dioxyde de silicium, nitrure de silicium ou autre matière transparente et résistante aux environnements typiques dans la vie du produit ;
- la préparation du composant horloger avant le dépôt des couches susmentionnées comprend une étape de lavage ;
- le composant horloger présente des décorations et/ou un état de surface souhaité ;
- Le gaz réactif pendant le dépôt de la couche diffusante est de l'oxygène ou de l'azote ou un mélange des deux.

L'invention concerne également un composant horloger présentant un revêtement de couleur blanche obtenu grâce au procédé conforme à l'invention.

### Brève description des figures

D'autres caractéristiques et avantages de l'invention apparaîtront à la lecture de la description détaillée suivante donnée à titre d'exemple nullement limitatif, en référence aux dessins annexés dans lesquels :
- La figure 1 représente schématiquement un substrat avec un revêtement blanc obtenu selon le procédé de l'invention ;
- la figure 2 représente schématiquement les étapes du procédé selon l'invention.

### Description détaillée de l'invention

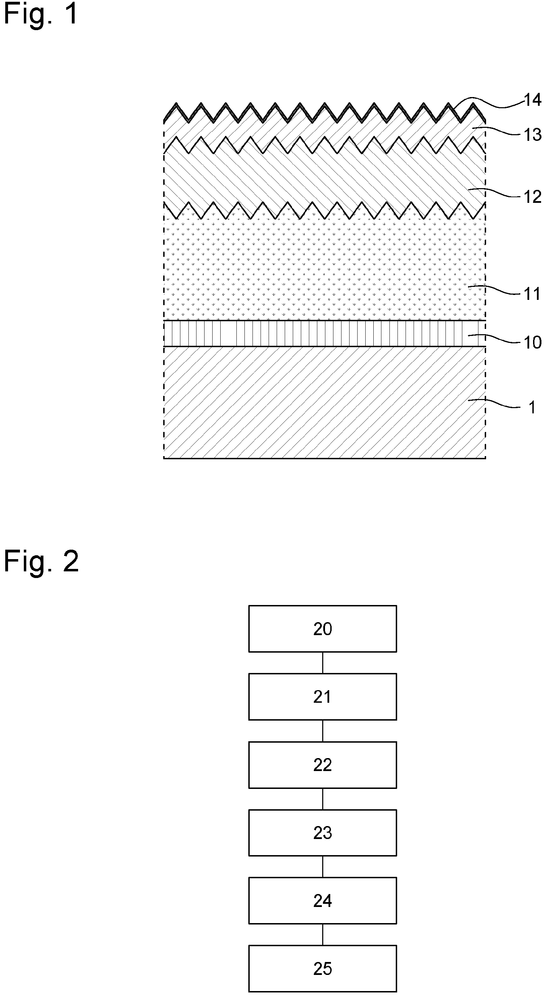

La figure 1 montre une représentation schématique de l'empilement de couches obtenu selon le procédé de l'invention.

Selon un aspect de l'invention, la déposition des revêtements conférant une couleur blanche à la surface de l'article décoratif est effectuée par une succession de dépôts PVD et ALD.

De préférence, une enceinte équipée d'un système de pulvérisation de type magnétron est utilisée dans le cadre de l'invention. Ledit système de pulvérisation comprend au moins une cible de pulvérisation en aluminium et des lignes d'injection de gaz permettant de réaliser, à l'intérieur de l'enceinte, une atmosphère contrôlée de type réactif ou inerte. Le fonctionnement de ce dispositif de pulvérisation est décrit dans la littérature scientifique et technique, est connu à l'homme de l'art et il ne sera répété ici que dans les grandes lignes.

Le procédé selon l'invention comprend une première étape 20 au cours de laquelle le substrat, ici le composant horloger, est nettoyé par plasma in-situ dans le système de déposition par polarisation du porte-substrat ou par tout autre méthode connue de l'homme du métier.

Le procédé comprend une deuxième étape 21 de déposition d'une première couche 10 sur le substrat 1, dite couche d'accroche. La couche d'accroche 10 peut être par exemple composée d'aluminium déposé par pulvérisation d'une source d'aluminium en atmosphère neutre, c'est-à-dire sans ajout de gaz réactif. La couche d'accroche peut également être composée de titane, d'aluminure de titane ou encore de chrome et a une épaisseur typiquement entre 30 nm et 100 nm, de préférence 50 nm.

La troisième étape 22 comprend le dépôt d'une deuxième couche 11. Lors de cette étape, une cathode équipée d'une cible d'aluminium est utilisée et un gaz réactif, tel que l'oxygène, l'azote ou un mélange des deux, est introduit dans l'enceinte et est maintenu à un taux tel qu'il permet d'obtenir une couche d'aluminium dopée à 0.5 à 10% atomiques en gaz réactif, dite couche diffusante 11. La couche diffusante 11 présente une épaisseur comprise entre 300 nm et 6000 nm, de préférence entre 1000 nm et 2000 nm, de préférence de 1500 nm.

Le but de cette troisième étape est d'influencer le dépôt des atomes d'aluminium avec le gaz réactif pour obtenir une couche d'oxyde d'aluminium (ou nitrure d'aluminium dans le cas de l'azote ou oxynitrure d'aluminium dans le cas du mélange d'azote et d'oxygène) présentant une structure cristalline à facettes. Une telle couche permet d'obtenir un effet diffusant de la lumière incidente grâce à sa structure cristalline à facettes.

Une quatrième 23 étape comprend la déposition d'une couche dure 12 sur la couche diffusante 11, la couche dure 12 étant choisie parmi les matériaux durs connus par l'homme de l'art, tels que le DLC, les nitrures ou carbonitrures, les oxydes de titane, le titane-aluminium, le silicium, l'aluminium ou le chrome.

La fonction de cette couche dure 12 est de protéger la couche diffusante d'aluminium qui est fragile et sensible rayures et aux endommagements mécaniques. La couche dure 12 doit aussi épouser la texture de la couche diffusante afin de préserver l'aspect diffusant du composant horloger. La couche dure 12 présente une épaisseur entre 200 nm et 3000 nm, de préférence entre 400 nm et 2000 nm, de préférence de 1000 nm.

Lors d'une cinquième étape 24, une couche d'un métal pur 13 est déposée sur la couche dure 12. Cette couche de métal pur 13 sert à masquer la couleur de la couche dure 12 et rendre le composant horloger blanc diffusant. La couche finale de métal pur 13 présente une épaisseur comprise en 20 nm et 400 nm, de préférence de 200 nm.

La couche de métal pur 13 est réalisée à partir d'un métal à haute réflectivité choisi parmi l'aluminium, l'argent, le rhodium ou le chrome.

Afin d'augmenter encore la réflectivité du composant horloger et donc son aspect « blanc », une couche transparente 14 dite couche « booster » est déposée dans une sixième étape 25.

Cette couche transparente 14 est constituée d'un empilement de couches minces diélectriques de matériaux transparents avec indices de réfraction et épaisseurs choisis de sorte que, par l'effet d'interférence, la valeur de L* dans l'espace chromatique CIE 1976 du composant horloger augmente par rapport à celle sans l'empilement, tout en conservant sa teinte (a*,b*). L'indice de réfraction est, par exemple, entre 1,38 (comme celui du MgF₂) et 2,6 (comme le TiO₂) à 633 nm de longueur d'onde et l'épaisseur entre 5 nm et 500 nm.

Cette couche transparente 14 sert aussi à protéger les couches précédemment déposées de la corrosion par les environnements typiquement rencontrés pendant la vie d'une montre. Si cette couche 14 n'est pas nécessaire (p. ex. dans le cas où l'effet « blanc » est satisfaisant sans ladite couche 14), elle peut être omise.

Finalement, au cours d'une septième étape 26, une sixième couche de protection 15 transparente est déposée, de préférence par une méthode de déposition ALD. La couche de protection 15 est composée de l'un des matériaux suivants : le dioxyde de titane, l'oxyde d'aluminium, le dioxyde de silicium, ou de nitrure de silicium. Cette étape est nécessaire dans le cas où l'étape 25 est omise ou si l'empilement de cette étape n'assure pas la protection suffisante des couches. Ainsi, la couche diffusante 11 couverte de la couche de métal pur 13 réfléchit efficacement la lumière blanche de manière diffuse, conférant une couleur blanche au substrat traité tout en conservant les détails de sa finition de surface et de sa décoration.

Premier exemple de réalisation du procédé selon l'invention :
- le substrat 1 est nettoyé par plasma in-situ dans l'enceinte de déposition par polarisation du porte-substrat ;
- une couche d'accroche d'aluminium est déposée en utilisant une cible d'aluminium sans ajout de gaz réactif ;
- ensuite, sans éteindre la cathode, de l'oxygène est introduit dans l'enceinte de déposition, le flux d'oxygène est choisi et maintenu tel qu'une couche d'aluminium à 1600 nm et avec contenu d'oxygène entre 0.5 et 10 at% est déposée avec une structure cristalline diffusante ;
- ensuite, sans éteindre la cathode, le flux d'oxygène est augmenté et maintenu à une valeur qui permet d'obtenir une couche dure de 1000 nm et avec une composition sensiblement proche de celle de l'Al2O3 ;
- ensuite, sans éteindre la cathode, le flux d'oxygène est arrêté complètement afin de finir la déposition de l'empilement avec une fine couche d'aluminium pur de 100 nm, sans dopage d'oxygène, qui donne à l'empilement un aspect blanc diffusant ;
- une fois que l'épaisseur souhaitée de la couche d'aluminium pur est atteinte, le procédé de déposition PVD est terminé et une couche « booster » et/ou de protection transparente est déposée par la méthode de déposition ALD.

Deuxième exemple de réalisation du procédé selon l'invention :
- le substrat 1 est nettoyé par plasma in-situ dans l'enceinte de déposition par polarisation du porte-substrat ;
- une couche d'accroche d'aluminium est déposée en utilisant une cible d'aluminium sans ajout de gaz réactif ;
- ensuite, sans éteindre la cathode, de l'azote est introduit dans l'enceinte de déposition, le flux d'azote est choisi et maintenu tel qu'une couche d'aluminium à 800 nm et avec contenu d'azote entre 0.5 et 10 at% est déposée avec une structure cristalline diffusante ;
- une fois que l'épaisseur souhaitée de la couche dopée en azote est atteinte, une couche dure de TiN de 1000 nm est déposée sur la couche d'aluminium dopée en azote ;
- ensuite, une fine couche d'aluminium pur à 160 nm est déposée afin d'obtenir l'aspect blanc diffusant de l'empilement ;
- une fois que l'épaisseur souhaitée de la couche d'aluminium pur est atteinte, le procédé de déposition PVD est terminé et un empilement transparent « booster » par la méthode de déposition ALD Cet empilement est constitué de 30 nm à 90 nm d'oxyde d'aluminium et de 20 nm à 100 nm d'oxyde de titanium et a la fonction d'augmenter encore la réflexion de la couche d'aluminium pur, ce qui augmente encore l'aspect blanc diffusant de l'empilement.

Le substrat, ou composant horloger, présente une surface polie, structurée ou décorée, par exemple une surface gravée, perlée, satinée, à côtes de Genève, à colimaçonnage, guillochée, soleillée, ciselée, etc. Le revêtement décoratif blanc de l'invention est suffisamment mince pour permettre de distinguer nettement la décoration et restituer l'état de surface du substrat sous-jacent. On obtient alors une surface blanche d'aspect « porcelaine » et décorée. L'état de surface et la topographie du substrat sont conservés et parfaitement perceptibles/visibles une fois le revêtement déposé. Ainsi, un substrat brillant avec un perlage conservera son aspect brillant et le perlage sera visible. De même, un substrat mat avec des côtes de Genève conservera son aspect mat et les côtes de Genève seront parfaitement visibles.

Le procédé de l'invention permet de déposer un revêtement de couleur blanche « porcelaine » sur tout type de composants horlogers afin d'obtenir des articles décoratifs particulièrement attrayants. On peut par exemple déposer un revêtement blanc par le procédé selon l'invention sur des composants d'habillage interne et de mouvement tels que cadrans, aiguilles, appliques, ponts, platines, barillets, masses oscillantes, etc. Par ailleurs, le procédé selon l'invention peut aussi être appliqué aux articles de bijouterie.

Ainsi, il est possible d'obtenir un composant horloger ayant un aspect blanc porcelaine tout en conservant l'état de surface et les décorations du composant.

## Revendications

1. Procédé de décoration d'un composant horloger (1) avec un revêtement blanc comprenant les étapes suivantes :
- préparation du composant horloger (1) et installation dudit composant dans une enceinte de déposition ;
- dépôt d'une couche d'accroche métallique (10) sur tout le composant horloger via un dépôt physique en phase vapeur ;
- dépôt d'une couche diffusante (11) en aluminium sur tout le composant, sous un flux d'un gaz réactif, le taux du gaz réactif étant maintenu de manière à obtenir une couche d'aluminium dopée à 0.5% à 10% atomiques en gaz réactif, de sorte que la couche d'aluminium cristallise sous la forme d'une structure cristalline à facettes, via un dépôt physique en phase vapeur ;
- dépôt d'une couche dure (12) sur ladite couche diffusante (11) pour augmenter la résistance de la couche diffusante (11) contre les rayures et autres endommagements mécaniques, tout en préservant la texture de la couche diffusante ;
- dépôt d'une couche de métal pur (13) pour augmenter la réflectivité des couches déposées précédemment ;
- dépôt d'une couche transparente (14), par la méthode ALD ou autre méthode de dépôt sous vide, pour augmenter l'aspect blanc diffusant par effet interférentiel, et pour protéger chimiquement les couches déposées dans les étapes précédentes ;
- alternativement, dépôt d'une couche de protection (15) transparente par la méthode ALD ou autre méthode de dépôt sous vide.

2. Procédé de décoration selon la revendication 1, **caractérisé en ce que** la couche d'accroche (10) est une couche métallique ou d'un alliage métallique choisi parmi : l'aluminium, le titane, l'aluminure de titane ou le chrome.

3. Procédé de décoration selon l'une des revendications 1 ou 2, **caractérisé en ce que** la couche d'accroche (10) présente une épaisseur comprise entre 30 nm et 100 nm, de préférence de 50 nm.

4. Procédé de décoration selon l'une des revendications 1 à 3, dans lequel la couche diffusante (11) présente une épaisseur comprise entre 300 nm et 6000 nm, de préférence entre 1000 nm et 2000 nm, de préférence de 1500 nm.

5. Procédé de décoration selon l'une des revendications 1 à 4, dans lequel la couche dure (12) présente une épaisseur entre 100 nm et 3000 nm, de préférence entre 400 nm et 2000 nm, de préférence de 1000 nm.

6. Procédé de décoration selon l'une des revendications 1 à 5, dans lequel la couche dure (12) est réalisée en un matériau choisi parmi le DLC, les nitrures ou carbonitrures, les oxynitrures ou les oxydes de titane, de titane aluminium, de silicium, d'aluminium, le nickel ou le chrome.

7. Procédé de décoration selon l'une des revendications 1 à 6, dans lequel la couche de métal pur (13) présente une épaisseur d'au moins 5 nm.

8. Procédé de décoration selon l'une des revendications 1 à 7, dans lequel la couche de métal pur (13) est réalisée parmi les métaux à haute réflectivité comme l'aluminium, l'argent, le rhodium ou le chrome.

9. Procédé de décoration selon l'une des revendications 1à 8, dans lequel la couche transparente (14) comprend un empilement de couches diélectriques transparentes.

10. Procédé de décoration selon la revendication 9, les couches diélectriques transparentes présentent un indice de réfraction entre 1,38 et 2,6 à 633 nm longueur d'onde et une épaisseur entre 5 nm et 500 nm.

11. Procédé de décoration selon l'une des revendications 1 à 10, dans lequel la couche de protection (14) présente une épaisseur comprise entre 0.5 nm et 20 nm, de préférence de 2 nm.

12. Procédé de décoration selon l'une des revendications 1 à 11, dans lequel la couche de protection (14) est choisie parmi les matériaux suivants : dioxyde de titane, oxyde d'aluminium, dioxyde de silicium, nitrure de silicium.

13. Procédé de décoration selon l'une des revendications 1 à 12, dans lequel le gaz réactif utilisé pour la couche diffusante (11) est de l'oxygène ou de l'azote ou un mélange des deux.

14. Composant horloger tel qu'un cadran, une aiguille, une applique, un pont, une platine, une masse oscillante, un barillet, un fermoir, avec une surface blanche obtenue par le procédé selon l'une des revendications 1 à 13.
